# EUROPÄISCHE PATENTANMELDUNG

(11) **EP 2 034 532 A1**
(43) Veröffentlichungstag der Anmeldung: **11.03.2009**
(21) Anmeldenummer: 08104837.3
(22) Anmeldetag: 23.07.2008
(51) Int. Cl.: H01L 41/053, H01L 41/22, F02M 51/06

(54) **Piezoaktormodul mit einem Schutzschichtsystem und ein Verfahren zu dessen Herstellung**

(30) Priorität: 06.09.2007 DE 102007042402
(71) Anmelder: Robert Bosch GmbH, 70442 Stuttgart (DE)
(72) Erfinder: Gebhard, Michael, 96135 Stegaurach (DE); Schlegl, Nicole, 73635 Rudersberg (DE)

(57) **Zusammenfassung**

Es wird ein Piezoaktormodul mit wenigstens einem Piezoaktor (2) vorgeschlagen, der zwischen einem Aktorkopf (3) und einem Aktorfuß (4) eingespannt ist und wobei zumindest der Piezoaktor (2) mit einem Schutzschichtsystem (5) versehen ist. Das mindestens eine Umfassungselement (6) ist zur dichten Befestigung des Schutzschichtsystems (5) am Aktorkopf (3), am Aktorfuß (4) und/oder am Piezoaktor (2) vorgesehen, wobei das mindestens eine Umfassungselement (6) aus einem Material mit geringem thermischen Ausdehnungskoeffizienten besteht und mittels eines äußeren Spannelements oder mittels eines elektromagnetischen Umformverfahrens auf das Schutzschichtsystem (5) pressbar ist.

## Beschreibung

### Stand der Technik

Die Erfindung betrifft ein Piezoaktormodul mit einem Schutzschichtsystem und ein Verfahren zu dessen Herstellung gemäß der Gattung des Hauptanspruchs und des nebengeordneten Verfahrensanspruchs.

Ein solches Piezoaktormodul kann beispielsweise in einem Piezoinjektor zur zeitpunkt- und mengengenauen Dosierung von Kraftstoff in einem Verbrennungsmotor eingesetzt werden. Der Piezoinjektor besteht im wesentlichen aus einem Haltekörper für das Piezoaktormodul und mindestens einem im Piezoaktormodul angeordneten Piezoaktor mit zwischen einem Aktorkopf und einem Aktorfuß angeordneten, übereinandergestapelten Piezoelementen, die jeweils aus mit Innenelektroden eingefassten Piezolagen bestehen.

Die Piezoelemente des Piezoaktors sind unter Verwendung eines Materials mit einer geeigneten Kristallstruktur (Piezokeramik) für die Piezolagen so aufgebaut, dass bei Anlage einer äußeren Spannung an die Innenelektroden eine mechanische Reaktion der Piezoelemente erfolgt, die in Abhängigkeit von der Kristallstruktur und der Anlagebereiche der elektrischen Spannung einen Druck oder Zug in eine vorgebbare Richtung darstellt. Der Piezoaktor ist bei einem Piezoinjektor mit einer Düsennadel verbunden, sodass durch Anlegen einer Spannung an die Piezoelemente eine Düsenöffnung freigegeben wird.

Diese Common Rail Injektoren können dabei so aufgebaut werden, dass eine indirekt vom Piezoaktor gesteuerte Düsennadel vorhanden ist, wobei der Piezoaktor direkt oder indirekt vom Druck des Kraftstoffs umgeben ist und zwischen der Düsennadel und dem Piezoaktor lediglich ein hydraulischer Kopplungsraum vorgesehen ist. Wenn die Piezoaktoren sich dabei im Niederdruckbereich des Kraftstoffs (ca. 60 bar) befinden, wie es bei indirekt gesteuerten Nadelbewegungen der Fall ist, so kann hier durchaus eine Metallhülsenabdichtung des Piezoaktors mit einer Membran als hub- und/oder temperaturausgleichendes Element realisiert werden.

In Diesel-Piezoinjektoren werden bei der so genannten direkten Düsennadelsteuerung die Piezoaktoren direkt im Dieselkraftstoff unter Hochdruck (ca. 2000 bar) betrieben, wobei die zuvor erwähnte relativ starre Hülsen-/Membranabdichtung den hohen Systemdrücken und den höheren Hubbewegungen des Piezoaktors unter den zur Verfügung stehenden Platzverhältnissen nicht standhalten würde.

Zum Schutz der Piezoelemente des Piezoaktors, beispielsweise auch im Hinblick auf deren elektrische Isolation, ist es daher auch bekannt, den Piezoaktor mit einem Elastomer zu umhüllen. Da die Anwesenheit von Kraftstoff, insbesondere hinsichtlich seiner leitfähigen Bestandteile, auf der Oberfläche des Piezoaktors zu einem elektrischen Überschlag zwischen den Elektroden und somit dem Versagen des Piezoaktors führen kann, muss der Piezoaktor vor dem direkten Kontakt mit dem Kraftstoff auch durch entsprechende Dichtheit an den Naht- oder Verbindungsstellen geschützt werden.

Aus der DE 101 39 871 A1 ist ein Piezoinjektor mit einem über einen hydraulischen Druckübersetzer auf ein Ventilglied einwirkenden Aktormodul bekannt, bei dem die Piezoelemente des Piezoaktors in einer mit einem metallischen Wellbalg versehenen Umhüllung angeordnet sind.

Aus der WO 2001 48834 A2 ist bekannt, dass die elektrische Isolation eines Piezoaktors mittels eines Schutzmantels aus Kunststoff vorgesehen wird, der beispielsweise durch Spritzgießen aufgebracht wird. Ferner ist aus der US 7 036 198 B2 bekannt, dass dieses Schutzschichtsystem aus einem Schrumpfschlauch gebildet wird, der durch einen Schrumpfprozess die Abdichtung gegenüber dem umgebenden Medium bewirkt.

Die kritischen Stellen der Abdichtung sind hierbei die Anbindungen der Enden der Umhüllung bzw. des Schutzschichtsystems insbesondere an den Aktorkopf und/oder an den Aktorfuß, um auch hier eine gute Dichtheit dauerhaft zu gewährleisten.

Offenbarung der Erfindung

Die Erfindung geht von einem eingangs beschriebenen Piezoaktormodul mit einem oder mehreren Piezoaktoren aus, der oder die zwischen einem Aktorkopf und einem Aktorfuß eingespannt sind und wobei zumindest der Piezoaktor mit einem Schutzschichtsystem versehen ist. Gemäß der Erfindung ist ein Umfassungselement zur Befestigung des Schutzschichtsystems am Aktorkopf, am Aktorfuß und/oder am Piezoaktor vorgesehen, das in vorteilhafter Weise aus einem Material mit geringem thermischen Ausdehnungskoeffizienten besteht und mittels eines äußeren Spannelements auf das Schutzschichtsystem pressbar ist.

Das mindestens eine Umfassungselement zur Anlage am Schutzschichtsystem kann dabei bevorzugt aus Invar oder einer Invar-Legierung hergestellt sein, das in etwa ein Viertel des Ausdehnungskoeffizienten des Materials des Aktorkopfs oder des Aktorfußes aufweist. Das erfindungemäße Piezoaktormodul kann dabei in vorteilhafter Weise mit einem Schutzschichtsystem aus einer oder mehreren Schichten eines polymeren oder metallischen Materials gebildet werden.

Alternativ zum Spannelement kann das mindestens eine Umfassungselement auch aus einem Material mit geringem thermischen Ausdehnungskoeffizienten bestehen und außen auf das Umfassungselement ein Teil aus elektrisch gut leitendem Material aufgebracht werden, das durch elektromagnetisches Umformen aufpressbar ist. Das äußere Teil kann dabei auf einfache Weise auch nach dem elektromagnetischen Umformen entfernt werden.

Das elektromagnetische Umformverfahren ist für sich gesehen beispielsweise aus der DE 20 2004 014 6582 U1 bekannt, in der beschrieben ist, wie das elektromagnetische Umformen bei elektrisch und/oder magnetisch leitenden Werkstücken derat vorgenommen werden kann, dass eine Materialverformung in einer für den jeweiligen Anwendungsfall erforderlichen Form und Richtung durchgeführt werden kann.

Gemäß eines vorteilhaften Verfahrens zur Herstellung eines solchen Piezoaktormoduls werden in einem ersten Verfahrensschritt der Piezoaktor und zumindest Teile des Aktorkopfes und/oder des Aktorfußes mit dem Schutzschichtsystem beschichtet, in einem zweiten Verfahrensschritt wird das Umfassungselement, bestehend aus dem inneren und dem äußeren Teil, auf das Schutzschichtsystem im Bereich des Aktorkopfs und/oder des Aktorfußes geführt und in einem dritten Verfahrensschritt wird mit einem federnden Spannelement oder mittels einer mit dem elektromagnetischen Umformverfahren bewirkte Schrumpfung eines solchen Spannelements das Umfassungselement dichtend auf das Schutzschichtsystem am Aktorkopf und/oder am Aktorfuß angedrückt.

Das Schutzschichtsystem wird bei dem erfindungsgemäßen Piezoaktormodul durch Verwendung von Materialien mit geringem thermischen Ausdehnungskoeffizienten beim Umfassungselement an den Piezoaktor oder das Piezoaktormodul mit dem Aktorkopf und dem Aktorfuß angebunden und dadurch in vorteilhafter Weise mit einfachen Mitteln dauerhaft gegenüber umgebenden Medien abgedichtet. Der mechanische Druck für die Anbindung kann dann beispielsweise durch das Aufbringen des Spannelements auf das Umfassungselement aus einer entsprechenden Legierung, vorzugsweise auch mit Invar, oder durch ein Fügen eines solchen Spannelements mittels dem an sich bekannten elektromagnetischen Umformen realisiert werden.

Der besondere Vorteil der Verwendung dieser Materialien besteht darin, dass sie einen geringen thermischen Ausdehnungskoeffizienten besitzen und dadurch in dem Fall, dass im Betrieb des Piezoaktors oder des Piezoaktormoduls es zu einer Temperaturerhöhung kommt, sich der Piezoaktor bzw. die in der Regel metallischen Anbindeteile Aktorkopf und Aktorfuß stärker ausdehnen als das Umfassungselement, vorzugsweise aus Invar. Dadurch wird die Spannkraft auf das Schutzschichtsystem erhöht, was zu einer Verbesserung der Abdichtung im Anbindebereich führt und ein Unterwandern des Schutzschichtsystems mit zum Beispiel Kraftstoff oder generell mit den umgebenden Medien verhindert.

Eine solche vorgeschlagene Anbindung des Schutzschichtsystems ist besonders dann vorteilhaft, wenn ein Verschweißen oder Löten des Schutzschichtsystems nicht möglich ist, insbesondere bei einer Verwendung eines Polymerschutzsystems, wie zum Beispiel ein Schrumpfschlauch oder ein Formschlauch.

### Kurze Beschreibung der Zeichnungen

Die Erfindung wird nachfolgend anhand des in den Zeichnungen gezeigten Ausführungsbeispiels erläutert. Dabei zeigen:
Figur 1 einen Schnitt durch ein Piezoaktormodul mit einem Piezoaktor, einem Aktorkopf, einem Aktorfuß und mit einem den Piezoaktor umfassenden Schutzschichtsystem, das mit Umfassungselementen am Aktorkopf und am Aktorfuß angebunden ist und
Figur 2 einen Schnitt ausgehend von der Figur 1 mit einer detaillierten Darstellung des Schutzschichtsystems mit den Umfassungselementen.

### Ausführungsformen der Erfindung

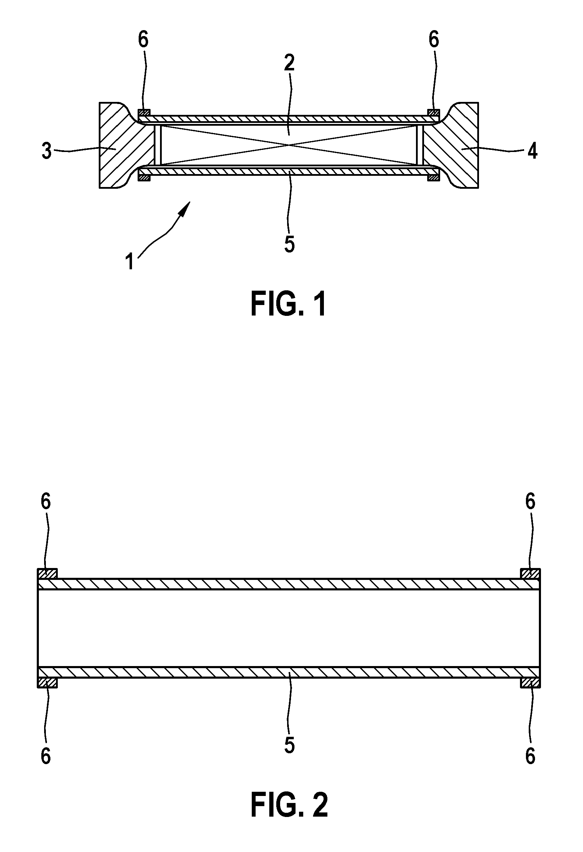

In Figur 1 ist ein Piezoaktormodul 1, beispielsweise für einen Piezoinjektor im Schnitt gezeigt, der zur Nadelhubsteuerung in einem Einspritzsystem für Kraftstoff bei einem Verbrennungsmotor eingesetzt werden kann, wie es eingangs anhand des Standes der Technik beschrieben ist.

Das Piezoaktormodul 1 weist einen Piezoaktor 2 oder eine Aneinanderreihung von mehreren solcher Piezoaktoren 2 auf, die mit den in der Beschreibungseinleitung beschriebenen Piezoelementen zur Bewirkung eines mechanischen Hubs in der Längserstreckung des Piezoaktormoduls 1 aufgebaut sind. An der linken Stirnseite des Piezoaktors 2 ist hier ein Aktorkopf 3 und an der rechten Stirnseite des Piezoaktors 2 ist ein Aktorfuß 4 gezeigt. Der Piezoaktor 2 ist von einem Schutzschichtsystem 5 aus einer oder mehreren Lagen umhüllt, das mittels der Umfassungselemente 6 am Aktorkopf 3 und am Aktorfuß 4 mechanisch dichtend angebunden ist.

Figur 2 zeigt einen detailierteren Schnitt des Schutzschichtsystems 5 mit den Umfassungselementen 6 zur Befestigung des Schutzschichtsystems 5 am Aktorkopf 3, am Aktorfuß 4 und/oder am Piezoaktor 2, welches aus einem Material mit geringem thermischen Ausdehnungskoeffizienten besteht und mittels eines äußeren, hier nicht gezeigten Spannelements auf das Schutzschichtsystem 5 pressbar ist.

Die Umfassungselemente 6 zur Anlage am Schutzschichtsystem 5 sind dabei bevorzugt aus Invar oder einer Invar-Legierung hergestellt, so dass sie einen geringen thermischen Ausdehnungskoeffizienten besitzen und dadurch im Betrieb des Piezoaktors 2 oder des Piezoaktormoduls 1 bei einer Temperaturerhöhung sich der Piezoaktor 2 bzw. die in der Regel metallischen Anbindeteile Aktorkopf 3 und Aktorfuß 4 stärker ausdehnen als das Umfassungselement 6, so dass die Spannkraft auf das Schutzschichtsystem 5 erhöht wird, was zu einer Verbesserung der Abdichtung im Anbindebereich führt und ein Unterwandern des Schutzschichtsystems 5 mit zum Beispiel Kraftstoff verhindert.

Gemäß einer anderen Ausführungsform können die Umfassungselemente 6 auch außen mit einem Teil aus elektrisch gut leitendem Material versehen werden, das durch elektromagnetisches Umformen aufpressbar ist. Dieses Teil kann dann auf einfache Weise auch nach dem elektromagnetischen Umformen entfernt werden.

Somit kann mittels des auf das Piezoaktormodul 1 aufgepressten Umfassungselements 6 ein Schutz des Piezoaktors 2 im Inneren des Piezoaktormoduls 1 vor den äußeren an dem Schutzschichtsystem 5 vorbeiströmenden aggressiven Medien bei einem Einsatz als Piezoinjektor bewirkt werden.

## Patentansprüche

1. Piezoaktormodul mit einem oder mehreren Piezoaktoren (2), der oder die zwischen einem Aktorkopf (3) und einem Aktorfuß (4) eingespannt sind und wobei zumindest der Piezoaktor (2) mit einem Schutzschichtsystem (5) versehen ist, **dadurch gekennzeichnet, dass** mindestens ein Umfassungselement (6) zur dichten Befestigung des Schutzschichtsystems (5) am Aktorkopf (3), am Aktorfuß (4) und/oder am Piezoaktor (2) vorgesehen ist und dass das mindestens eine Umfassungselement (6) aus einem Material mit geringem thermischen Ausdehnungskoeffizienten besteht und mittels eines äußeren Spannelements auf das Schutzschichtsystem (5) pressbar ist.

2. Piezoaktormodul nach Anspruch 1, **dadurch gekennzeichnet, dass** das mindestens eine Umfassungselement (6) zur Anlage am Schutzschichtsystem (5) aus Invar oder einer Invar-Legierung hergestellt ist.

3. Piezoaktormodul nach Anspruch 1 oder 2, **dadurch gekennzeichnet, dass** der Spannring aus Invar oder einer Invar-Legierung hergestellt ist.

4. Piezoaktormodul mit einem oder mehreren Piezoaktoren (2), der oder die zwischen einem Aktorkopf (3) und einem Aktorfuß (4) eingespannt sind und wobei zumindest der Piezoaktor (2) mit einem Schutzschichtsystem (5) versehen ist, **dadurch gekennzeichnet, dass** mindestens ein Umfassungselement (6) zur dichten Befestigung des Schutzschichtsystems (5) am Aktorkopf (3), am Aktorfuß (4) und/oder am Piezoaktor (2) vorgesehen ist, das aus einem Material mit geringem thermischen Ausdehnungskoeffizienten besteht und außen auf das Umfassungselement (6) ein Teil aus elektrisch gut leitendem Material aufgebracht ist, das durch elektromagnetisches Umformen auf das Umfassungselement (6) pressbar ist.

5. Piezoaktormodul nach Anspruch 4, **dadurch gekennzeichnet, dass** das äußere Teil des Umfassungselements (6) nach dem elektromagnetischen Umformen entfernt ist.

6. Piezoaktormodul nach einem der vorhergehenden Ansprüche, **dadurch gekennzeichnet, dass** das Schutzschichtsystem (5) aus einer oder mehreren Schichten eines polymeren oder metallischen Materials besteht.

7. Verfahren zur Herstellung eines Piezoaktormoduls nach einem der vorhergehenden Ansprüche, **dadurch gekennzeichnet, dass** in einem ersten Verfahrensschritt der Piezoaktor (2) und zumindest Teile des Aktorkopfes (3) und/oder des Aktorfußes (4) mit dem Schutzschichtsystem (5) beschichtet werden, in einem zweiten Verfahrensschritt das Umfassungselement (6) auf das Schutzschichtsystem (5) im Bereich des Aktorkopfs (3) und/oder des Aktorfußes (4) geführt wird und in einem dritten Verfahrensschritt mit einem federnden Spannelement oder mit einem mit dem elektromagnetischen Umformverfahren geschrumpften Teil das Umfassungselement (6) auf das Schutzschichtsystem (5) am Aktorkopf (3) und/oder am Aktorfuß (4) angedrückt wird.

8. Verfahren nach Anspruch 7, **dadurch gekennzeichnet, dass** das äußere Teil (7) des Umfassungselements (6) nach dem elektromagnetischen Umformverfahren entfernt wird.

9. Verwendung eines Piezoaktormoduls nach einem der vorhergehenden Ansprüche, **dadurch gekennzeichnet, dass** der Piezoaktor (2) Bestandteil eines Piezoinjektors für ein Einspritzsystem für Kraftstoff bei einem Verbrennungsmotor ist, wobei der Kraftstoff das Schutzschichtsystem (5) umströmt.
